# EUROPEAN PATENT APPLICATION

(11) **EP 3 154 323 A1**
(43) Date of publication of application: **12.04.2017**
(21) Application number: 14893774.1
(22) Date of filing: 04.06.2014
(51) Int. Cl.: H05K 7/20, H02M 7/04, H02M 7/48

(54) **POWER DEVICE**

(71) Applicant: Toshiba Mitsubishi-Electric Industrial Systems Corporation, Tokyo 104-0031 (JP)
(72) Inventor: MATSUOKA, Yuji, Tokyo 104-0031 (JP); TAKAHASHI, Nobuhiro, Tokyo 104-0031 (JP)
(74) Representative: Zech, Stefan Markus
(86) International application number: PCT/JP2014/064851
(87) International publication number: WO 2015/186208

(57) **Abstract**

A power converter (1) includes an IGBT unit (2) and a transformer (3) provided in an inside and configured to become hot during operation and a fan (4) configured to produce an airflow (F) from an upper part to a lower part in the inside, and is configured to control the fan (4) to cool the IGBT unit (2) and the transformer (3), and to control the fan (4) to discharge dust in the inside to an outside.

## Description

### Technical Field

The present invention described herein relate generally to a power apparatus used in power equipment.

### Background Art

In general, power apparatuses used in power equipment often comprise cooling mechanisms which cool electrical components mounted in the inside. On the other hand, the electrical components may require measures against dust to prevent failures such as short circuits.

For example, as the measures against dust, disclosed is a cabinet unit housing rack which is structured to allow cabinet units to be housed in the inside, wherein housing chambers with heat dissipation ports open and air conducting chambers communicating with the housing chambers via the heat dissipation ports are arranged in tiers vertically, the air conducting chambers communicate with each other vertically, a blower fan is provided at an outlet of the top tier, and an exhaust duct connecting port equipped with an exhaust fan is formed at the air conducting chamber of the bottom tier (see Patent Literature 1). In addition, a power conditioner device having the structure in which a cooling wind does not strike a predetermined region such as a soldered face is disclosed (see Patent Literature 2).

However, if dust accumulates in the inside of a device, the cooling efficiency may decline. Moreover, if the measures against dust are taken, great restrictions are often imposed on the structure of the device as described above. Accordingly, the dust accumulating in the device is often removed by the hand of man.

### Citation List

### Patent Literature

Patent Literature 1: JP 2005-268546 A
Patent Literature 2: JP 2013-026547 A

### Summary of Invention

An object of the present invention is to provide a power apparatus which discharges accumulating dust to the outside and which is structurally versatile.

In accordance with an aspect of the present invention, a power apparatus comprises: a heating element provided in an inside and configured to become hot during operation; a fan configured to produce an airflow from an upper part to a lower part in the inside; cooling control means for controlling the fan in order to cool the heating element; and discharge control means for controlling the fan in order to discharge dust in the inside to an outside.

Brief Description of Drawings
FIG. 1 is a structural view showing a structure of a power converter according to an embodiment of the present invention.
FIG. 2 is a schematic view showing airflows in a board of the power converter according to the present embodiment.

Mode for Carrying Out the Invention Embodiments of the present invention will be described hereinafter with reference to the accompanying drawings.

### (Embodiment)

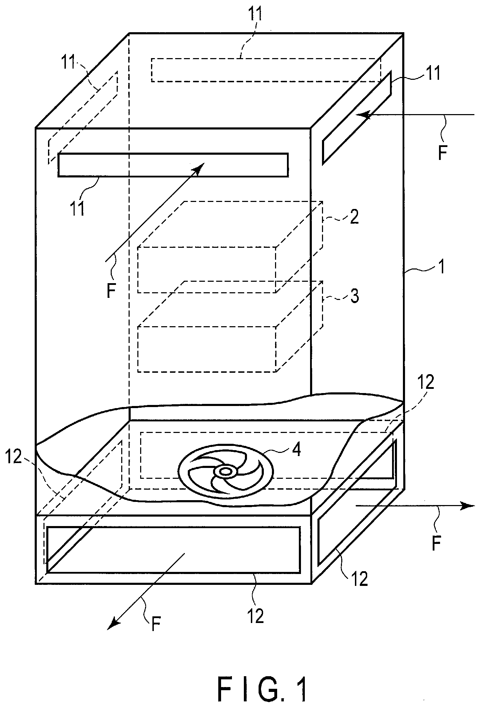

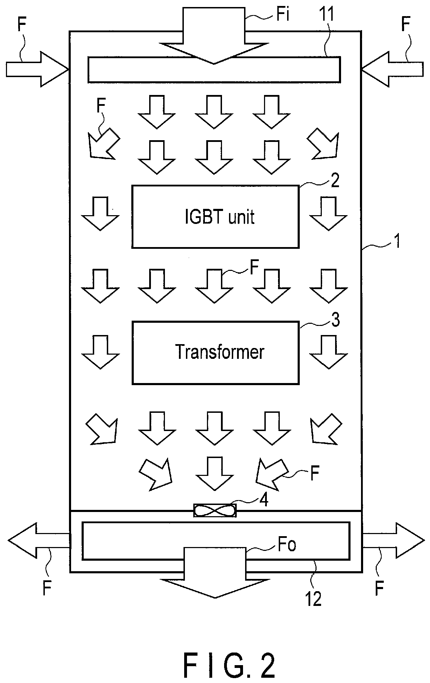

FIG. 1 is a structural view showing a structure of a power converter 1 according to an embodiment of the present invention. FIG. 2 is a schematic view showing airflows F in the power converter 1 according to the present embodiment. The same portions in the drawings are given the same reference numbers, and a detailed explanation thereof will be omitted. Different portions will be mainly described.

The power converter 1 is a power apparatus used in a power system or used as power equipment to control the power system. The power converter 1 is a device having a boardlike structure. Intake ports 11 for taking air in are provided in four side surfaces of the upper part of the power converter 1. Although it is unnecessary to provide the intake ports 11 with air filters, etc., for preventing the entrance of dust, the air filters, etc., may be provided. Discharge ports 12 for discharging air and dust are provided in four side surfaces of the lower part of the power converter 1.

The power converter 1 comprises an insulated-gate bipolar transistor (IGBT) unit 2, a transformer 3, and a fan 4. Devices accommodated in the board of the power converter 1, such as the IGBT unit 2 and the transformer 3, are all dustproof. For example, electronic components vulnerable to dust are covered in such an airtight manner as to prevent the entrance of dust. The IGBT unit 2 or the transformer 3 may has a highly airtight structure as a whole or may be covered by a highly airtight housing.

The IGBT unit 2 is a unit in which an IGBT (switching element) constituting a power conversion circuit is accommodated. The IGBT unit 2 is a heating element which becomes the hottest during operation and requires cooling the most in the structure of the power converter 1. The switching element is not limited to an IGBT, and may be any kind of semiconductor.

The transformer 3 constitutes the power conversion circuit together with the IGBT unit 2. The transformer 3 is a heating element which becomes hot during the operation of the power converter 1, and is a device which requires cooling.

The IGBT unit 2 and the transformer 3 may be provided anywhere in the board, as long as they are provided in such a manner that they do not completely interrupt the airflows F produced by the fan 4 and are cooled by the airflows F.

The fan 4 is attached to the lower part (bottom surface) in the board of the power converter 1. For example, the fan 4 is a sirocco fan (multiblade blower). The rate of rotation, operation mode, etc., of the fan 4 are determined under the control of a control module provided in the fan 4. The control module may be provided independently of the fan 4. The fan 4 takes air in vertically from the upper part of the power converter 1, and discharges air horizontally from the lower part of the power converter 1. When the fan 4 rotates, air is taken in from the intake ports 11 of the power converter 1, and air is discharged from the discharge ports 12. The airflows F as shown in FIG. 2 are thereby produced in the power converter 1. Inside the power converter 1, the airflows F from the upper part at which the intake ports 11 are provided toward the fan 4 provided at the lower part are produced.

The fan 4 performs two main operations. One is a cooling operation in which the IGBT unit 2 and the transformer 3 mounted in the board are cooled. The other is a discharge operation in which dust collecting in the board of the power converter 1 is discharged to the outside.

Normally, the fan 4 performs the cooling operation. It suffices that the rate of rotation (speed of rotation) of the fan 4 in the cooling operation is greater than or equal to the minimum rate of rotation at which the IGBT unit 2 and the transformer 3 can be cooled. If the cooling operation is performed, the rate of rotation of the fan 4 may be constant or variable depending on the temperature, surroundings or time, or the cooling operation may be performed intermittently. When the fan 4 performs the cooling operation, the airflows F in the board of the power converter 1 serve as cooling winds cooling the IGBT unit 2 and the transformer 3.

In the situation in which dust accumulates in the inside of the power converter 1, the fan 4 performs the discharge operation. When the fan 4 performs the discharge operation, the dust collecting in the board, for example, on the bottom surface of the power converter 1 is blown by the airflows F produced in the board, and discharged to the outside of the board of the power converter 1. The rate of rotation of the fan 4 is greater in the discharge operation than in the cooling operation. The timing with which the discharge operation is performed may be based on a predetermined time interval or time, a detection result of a sensor which can estimate the degree to which dust accumulates in the board, or a manually issued command to perform the discharge operation. Also when the fan 4 performs the discharge operation, the IGBT unit 2 and the transformer 3 are cooled by the airflows F produced in the board.

According to the present embodiment, the power converter which normally cools a device mounted in the inside of the power converter 1 and when dust accumulates, causes the fan 4 to discharge the dust to the outside of the power converter 1, thereby discharging the accumulating dust to the outside, and which is structurally flexible can be provided.

In the present embodiment, the power apparatus has been described as a power converter, but is not restricted to this. The power apparatus may be any power apparatus as long as a device which requires cooling is mounted therein. In addition, even if the power apparatus is a power converter, any power conversion circuit may be mounted therein. For example, the power conversion circuit may be a single-phase circuit, a three-phase circuit, or other circuits. In addition, two or more IGBT units 2 or two or more transformers 3 may provided, a capacitor as a heating element which requires cooling may be added, and other elements or devices, etc., may be included. In an arbitrary power apparatus, the same advantages can be obtained by providing the fan 4 which performs the cooling operation and the discharge operation and making the power apparatus have the same structure as in the embodiment.

In the present embodiment, the fan 4 may have any form or structure, and be attached to any position, as long as the fan 4 can produce an airflow from the upper part to the lower part in the apparatus and discharge dust to the outside of the apparatus.

It is to be noted that the present invention is not restricted to the foregoing embodiments, and constituent elements can be modified and changed into shapes without departing from the scope of the invention at an embodying stage. Additionally, various inventions can be formed by appropriately combining a plurality of constituent elements disclosed in the foregoing embodiments. For example, several constituent elements may be eliminated from all constituent elements disclosed in the embodiments. Furthermore, constituent elements in the different embodiments may be appropriately combined.

## Claims

1. A power apparatus **characterized by** comprising:
a heating element provided in an inside and configured to become hot during operation;
a fan configured to produce an airflow from an upper part to a lower part in the inside;
cooling control means for controlling the fan in order to cool the heating element; and
discharge control means for controlling the fan in order to discharge dust in the inside to an outside.

2. The power apparatus of Claim 1, **characterized in that** the heating element is dustproof.

3. The power apparatus of Claim 1 or Claim 2, **characterized in that** the heating element includes a switching element of a power conversion circuit.

4. A method of controlling a power apparatus including a heating element provided in an inside and configured to become hot during operation, the method **characterized by** comprising:
controlling a fan configured to produce an airflow from an upper part to a lower part in the inside in order to cool the heating element; and
controlling the fan in order to discharge dust in the inside to an outside.
